# EUROPEAN PATENT APPLICATION

(11) **EP 1 650 813 A1**
(43) Date of publication of application: **26.04.2006**
(21) Application number: 05109754.1
(22) Date of filing: 19.10.2005
(51) Int. Cl.: H01L 31/075

(54) **Thin-film solar cell of tandem type**

(30) Priority: 20.10.2004 JP 2004305164
(71) Applicant: MITSUBISHI HEAVY INDUSTRIES, LTD., Tokyo 108-8215 (JP)
(72) Inventor: Nakano, Youji, Mitsubishi Heavy Ind. Ltd., Kanazawa-ku, Yokohama, Kanagawa (JP); Yamashita, Nobuki, Mitsubishi Heavy Ind., Ltd., Kanazawa-ku, Yokohama, Kanagawa (JP)
(74) Representative: Bongiovanni, Simone

(57) **Abstract**

A thin-film solar cell of a tandem type includes a first conductive layer formed on a transparent substrate to which a sun light is input; a top solar cell layer formed on the first conductive layer; and a bottom solar cell layer laminated on the top solar cell layer to be connected with the top solar cell in series. A total generation electric current of the thin-film solar cell layer is determined based on a generation electric current of the bottom solar cell layer.

## Description

### Background of the Invention

### 1. Field of the Invention

The present invention relates to a thin-film solar cell of a tandem type.

### 2. Description of the Related Art

In a technical field of a solar cell, a solar cell with a high power generation efficiency has been developed. As one example, a solar cell of a tandem type has been studied. The conventional solar cell of the tandem type is provided with a transparent insulating substrate and a first transparent electrode formed on the substrate. The top solar cell is laminated on the first transparent electrode, and the bottom solar cell is laminated on the top solar cell. A second transparent electrode is formed on the bottom solar cell, and a back electrode is formed on the second transparent electrode. The top cell is provided with a p-type silicon layer (amorphous silicon layer), an i-type silicon layer (amorphous silicon layer), and an n-type silicon layer (amorphous silicon layer), all of which are laminated in this order. Also, the bottom solar cell is provided with a p-type silicon layer (crystalline silicon layer), an i-type silicon layer (crystalline silicon layer), and an n-type silicon layer (crystalline silicon layer), all of which are laminated in this order.

A part of the sunlight entering from a side of the transparent insulating substrate is subjected to a first photo-electric conversion into electrical energy in the top solar cell. Then, a component of the sunlight that is not absorbed in the top solar cell is subjected to a second photo-electric conversion into the electrical energy. Thus, an ultraviolet region in the sunlight spectrum is relatively increased at the time of the sun's meridian passage, and the generated power takes its peak under the sunlight spectrum at that time.

Conventionally, in order to realize high power generation efficiency, the solar cell was designed such that the generation electric current in the top solar cell determines the generation electric current in the whole solar cell. In this case, if the film thickness of the solar cell is made thicker, the generation electric current in each of the cells becomes large. Therefore, the film thickness of the top solar cell is made constant to fix the generation electric currents in the top solar cell, and then, the film thickness of the bottom solar cell is adjusted. Thus, the balance of the generation electric currents in the top solar cell and the bottom solar cell was freely set. That is, in the conventional solar cell, the generation electric current in the top solar cell determines total generation electric current in the whole solar cell.

However, when considering the power generation efficiency throughout the year, there are the following problems in the solar cell under the top solar cell determining rule to the total generation electric current. A problem is in that the power generation decreases when a sun light incident angle is low in the morning and the evening, the winter season, and so on, and when ultraviolet rays are absorbed at the time of cloudy weather, although the power generation is slightly increased at the time of the sun's meridian passage. Also, another problem is in that a light degradation rate is high in the amorphous silicon solar cell as the top solar cell, so that the power generation efficiency decreases after the light degradation in the top solar cell, resulting in unstable power generation efficiency. That is, a manufacturing technique is needed to form the top solar cell with a predetermined film thickness in a high reproducibility in consideration of an amount of the light degradation, in order to achieve a desired efficiency after stabilization.

In conjunction with the technique mentioned above, a report has been made as shown below. In the 2003 evaluation report "Research and Development of Photovoltaic Power Generation Technology: Silicon Crystalline Type Thin-Film Solar Cell Module Manufacturing Technology Development (2)" by the New Energy and Industrial Technology Development Organization, an internal light trapping technology using an "amorphous Si / intermediate transparent layer / thin-film polysilicon" hybrid structure is reported, in which a intermediate transparent layer is introduced between the top solar cell (amorphous silicon solar cell) and the bottom solar cell (thin-film polysilicon solar cell). As a result of consideration aimed at the improvement of a module performance on applying the above-mentioned structure to a large-area module, 13.5 percent has been accomplished as an initial conversion efficiency of a hybrid module with the aperture area of 3825 cm² (the substrate size of 910 mm * 455 mm). It has also been indicated that the hybrid module of the above-mentioned structure is superior in the power generation efficiency even in the large-area condition. Also, a consideration was made to a solar cell module capable of obtaining high power generation efficiency out of doors. Two kinds of hybrid modules: one module that the total generation electric current is determined by the top solar cell and the other module that the total generation electric current is determined by the bottom solar cell are compared each other in the change of the generated power throughout a day under the condition of a same sun light amount. As a result of the comparison, the hybrid module under the top solar cell determining rule of the total generation electric current indicated the power generation higher by 10 percent than the hybrid module under the bottom solar cell determining rule of the total generation electric current, since an air mass value comes close to 1.0 at the time of the meridian passage when the sun light amount becomes close to 1kW/m². Further, temperature dependency after exposure to outer environment and stabilization was examined by using SMAP (Spectrum Match Analyzing Procedure) regarding the two kinds of hybrid modules. The analysis result indicated that the change of the maximum output coincided with a change of the sunlight spectrum throughout a day and a change of module temperature. Thus, it was confirmed that the hybrid module of the top solar cell determining rule of the total generation electric current indicated a higher power generation efficiency under high sun light amount and low air mass. Through a light radiation acceleration test, it was confirmed that a F.F. of the top solar cell with an intermediate layer after stabilization became higher, compared with a conventional hybrid cell. Also, over 90 percent of a retention rate could be obtained under a light radiation condition of 5 SUN, 20 hours, and 50 °C. In addition, when each of the p/i/n layers in the thin-film polysilicon cell is formed in a same chamber for the improvement in throughput, the performance of it was equivalent to that of a conventional cell in which each of the p/i/n layers was formed in separate chambers.

### Summary of the Invention

An object of the present invention is to provide a thin-film solar cell of a tandem type that has a high power generation efficiency throughout a year and can be manufactured in a high productivity.

In an aspect of the present invention, a thin-film solar cell of a tandem type includes a first conductive layer formed on a transparent substrate to which a sun light is input; a top solar cell layer formed on the first conductive layer; and a bottom solar cell layer laminated on the top solar cell layer to be connected with the top solar cell in series. A total generation electric current of the thin-film solar cell layer is determined based on a generation electric current of the bottom solar cell layer.

Here, the thin-film solar cell may further include an intermediate transparent layer provided between the top solar cell layer and the bottom solar cell layer. In this case, the intermediate layer may be formed of a material selected from the group consisting of ZnO, ITO (Indium Thin Oxide) and SnO₂, as a main component. The thickness of the intermediate layer may be about 50 nm. Also, the absorptivity of light in the wavelength of 600 to 1200 nm by the intermediate transparent layer is preferably equal to or less than 1%. The intermediate transparent may function to reflect a wavelength region of a sun light, which should be used for power generation in the top solar cell layer, to the top solar cell layer.

Also, the film thickness of the top solar cell is preferably in a range of 200 to 400 nm, and the film thickness of the bottom solar cell layer is preferably in a range of 1 to 2.5 µm. More preferably, the film thickness of the bottom solar cell layer is in a range of 1.5 to 2.0 µm.

Also, the generation electric current in the bottom solar cell layer may be equal to or smaller than a generation electric current in the bottom solar cell layer under a sun light spectrum condition of AM (Air Mass) of 1.5. Also, the generation electric current in the bottom solar cell layer may be equal to or smaller than a generation electric current in the bottom solar cell layer under a condition of a sunlight spectrum at noon in March or September at a location where the thin-film solar cell layer is installed. In this case, the generation electric current in the bottom solar cell layer is preferably equal to or smaller than a generation electric current in the bottom solar cell layer by a value smaller than 1 mA/cm² under a sun light spectrum condition of AM (Air Mass) of 1.5.

Also, the top solar cell layer includes a p-type layer, an i-type layer and an n-type layer, and preferably the i-type layer is an amorphous layer. The bottom solar cell layer includes a p-type layer, an i-type layer and an n-type layer, and preferably the i-type layer is a crystalline layer. In this case, when the p-, i- and n-type layers of the top solar cell layer are formed on the first conductive layer in this order, the p-, i- and n-type layers of the bottom solar cell layer may be formed from a side of the first conductive layer in this order, or when the n-, i- and p-type layers of the top solar cell layer are formed on the first conductive layer in this order, the n-, i- and p-type layers of the bottom solar cell layer may be formed from a side of the first conductive layer in this order.

The main component of the top solar cell layer and the bottom solar cell layer is silicon.

### Brief Description of the Drawings

Fig. 1 is a cross sectional view schematically showing of a layer structure of a thin-film solar cell of a tandem type according to a first embodiment of the present invention;
Fig. 2 is a diagram showing performance of the thin-film solar cell of the tandem type according to the first embodiment of the present invention;
Fig. 3 is a cross sectional view schematically showing of a layer structure of a thin-film solar cell of a tandem type according to a second embodiment of the present invention; and
Fig. 4 is a diagram showing performance of the thin-film solar cell of the tandem type according to the second embodiment of the present invention;

### Description of the Preferred Embodiments

A thin-film solar cell of a tandem type of the present invention will be described in detail with reference to the attached drawings.

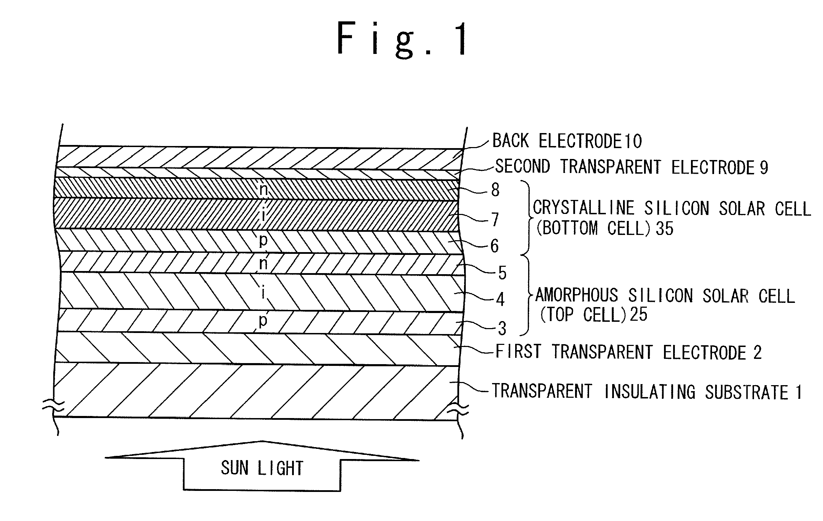

Fig. 1 shows the layer structure of the thin-film solar cell of the tandem type according to the first embodiment of the present invention. Referring to Fig. 1, the thin-film solar cell of the tandem type in the first embodiment is provided with a transparent insulating substrate 1 and a first transparent electrode 2 formed on the substrate 1. The thin-film solar cell of the tandem type in the first embodiment is further provided with an amorphous silicon solar cell as a top solar cell 25 formed on the electrode 2, and a crystalline silicon solar cell as a bottom solar cell 35 formed on the top solar cell 25. The thin-film solar cell of the tandem type in the first embodiment is further provided with a second transparent electrode 9 formed on the bottom solar cell 35 and a back electrode 10 formed o the electrode 9. The top solar cell 25 has a p-i-n structure, and is composed of a p-type amorphous silicon layer 3, an i-type amorphous silicon layer 4 and an n-type amorphous silicon layer 5. However, the top solar cell 25 may have an n-i-p structure. The bottom solar cell 35 has a p-i-n structure, and is composed of a p-type crystalline silicon layer 6, an i-type crystalline silicon layer 7 and an n-type crystalline silicon layer 8. However, the bottom solar cell 35 may have an n-i-p structure, when the top solar cell has the n-i-p structure.

Here, although the top solar cell 25 and the bottom solar cell 35 have the silicon layers, the components of the top solar cell and the bottom solar cell is not limited to pure silicon. The layer may be a layer containing silicon as a major component, such as a silicon carbide layer containing less than 50 percent of carbon, and a silicon germanium layer containing less than 20 percent of germanium. Even if several percent or below of other elements are contained, the same characteristic is shown when the silicon is substantially the major component.

Also, although it has been described that all the p-, i-, and n-type silicon layers in the amorphous solar cell as the top solar cell are amorphous, a crystallinity of the p-type layer and the n-type layer is not a problem, since the characteristic of the amorphous silicon solar cell is substantially determined depending on the major component of the i-type silicon layer. Similarly, although it has been described that all the p-, i-, and n-type silicon layers in the crystalline solar cell as the bottom solar cell are crystalline, the crystallinity of the p-type layer and the n-type layer is not a problem, since the characteristics of the crystalline silicon solar cell are substantially determined depending on the main component of the i-type silicon layer.

In the solar cell, when the film thickness is made thicker, the generation electric current in the cell becomes large. Therefore, when a balance of the generation electric currents in the top solar cell 25 and the bottom solar cell 35 should be determined, the film thickness of the top solar cell 25 is determined and then the film thickness of the bottom solar cell 35 is determined. If the film thickness of the top solar cell 25 is determined to be constant to fix the generation electric current in the top solar cell 25, the balance of the generation electric currents in the top solar cell 25 and the bottom solar cell 35 is freely set, by determining the film thickness of the bottom solar cell 35. In the first embodiment, the solar cell is designed in accordance with the bottom solar cell determining rule of the total generation electric current.

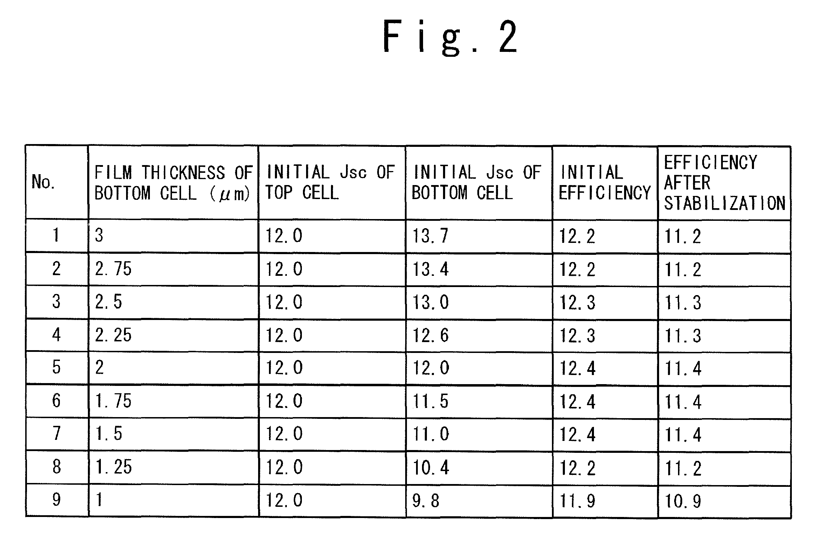

The film thickness of the amorphous silicon solar cell 25 as the top solar cell is preferably in a range of 200 to 400 nm. When the film thickness of the amorphous silicon solar cell 25 as the top solar cell is 350nm, the film thickness of the crystalline silicon solar cell 35 as the bottom solar cell is changed to various values, as shown in Fig. 2. Thus, a plurality of balances of the generation electric currents of the top solar cell and the bottom solar cell are set. Then, in each generation electric currents balance, a stabilization efficiency was measured under a sun light amount of AM (Air Mass) of 1.5. The stabilization efficiency means an efficiency after light degradation acceleration under the condition light of sun light radiation at 1 SUN, 100 mW/cm², and 50 °C, for 1000 hours.

Fig. 2 shows the results of initial power generation efficiency and stabilization power generation efficiency when the balance of the generation electric currents of the top solar cell 25 and the bottom solar cell 35 is changed. The stabilization power generation efficiency takes the maximum value when the film thickness of the bottom solar cell 35 is in a range of 1.5 µm to 2.0 µm. This indicates that an optimal setting condition is met when the generation electric current in the bottom solar cell 35 is equal to or is smaller by about 1 mA/cm² than the generation electric current in the top solar cell 25. That is, in this optimal setting condition, the total generation electric current is determined by the bottom solar cell 35. In the first embodiment, 1.5 µm is the optimum value as the film thickness of the bottom solar cell 35 in view of productivity.

A rated output of the solar cell is to be based on the sunlight spectrum of AM (Air Mass) 1.5. In order to obtain a high rated output, the generation electric current balance of the bottom solar cell layer 35 and the top solar cell layer 25 is designed such that the generation electric current in the bottom solar cell layer is smaller than that in the top solar cell layer, in the sunlight spectrum of AM 1.5. Through such a design, the high output can be obtained as a characteristic of a tandem solar cell, in present solar cell characteristic evaluation defined for crystalline solar cell evaluation.

In order to obtain a high effective output of the solar cell actually placed out of doors, it is necessary to take into consideration a sunlight spectrum condition in a place where the solar cell is to be located, and to design the solar cell such that the bottom solar cell determining rule of the total generation electric current is realized. Since the sunlight spectrum changes in the seasons, the sunlight spectrum at the time of the noon in March or September, which are the vernal equinox and the autumnal equinox, is applied as an average value. The film thickness of the bottom solar cell is optimized such that the bottom solar cell determining rule of the total generation electric current is met under that condition.

In the first embodiment, the thin-film solar cell of the tandem type set in the bottom solar cell determining rule of the total generation electric current is realized. Consequently, it is possible to realize a high power generation efficiency throughout the year. Also, by establishing the bottom solar cell determining rule of the total generation electric current, it is also possible to stably keep a stabilization efficiency even for a drop in the power generation efficiency after the degradation of the amorphous silicon solar cell 25 as the top solar cell. Further, for the reason of the bottom solar cell determining rule of the total generation electric current, a high deposition accuracy is not required for the film thickness of the amorphous silicon solar cell 25 as the top solar cell. That is, in the first embodiment, the stabilization efficiency is stable and the productivity is high, even if the film thickness ratio of the top solar cell and the bottom solar cell is not a perfect value to a certain extent.

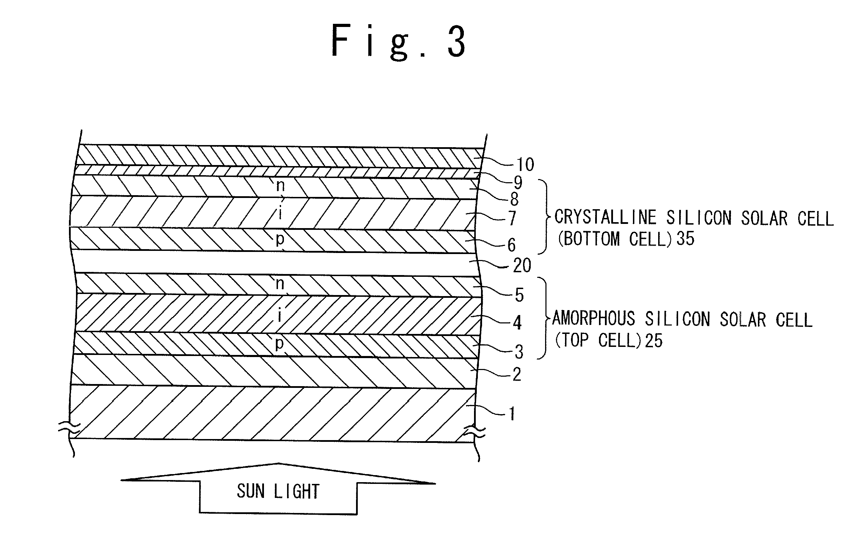

Fig. 3 shows a layer structure of the thin-film solar cell of the tandem construction according to the second embodiment of the present invention. Referring to Fig. 3, the thin-film solar cell of the tandem type in the second embodiment is provided with a transparent insulating substrate 1 and a first transparent electrode 2 formed on the substrate 1. The thin-film solar cell of the tandem type in the second embodiment is further provided with the amorphous silicon solar cell as the top solar cell 25 formed on the electrode 2, an intermediate transparent layer 20 formed on the top solar cell 25, and a crystalline silicon solar cell as a bottom solar cell 35 formed on the top solar cell 25. The thin-film solar cell of the tandem type in the second embodiment is further provided with a second transparent electrode 9 formed on the bottom solar cell 35 and a back electrode 10 formed o the electrode 9. The top solar cell 25 has a p-i-n structure, and is composed of a p-type amorphous silicon layer 3, an i-type amorphous silicon layer 4 and an n-type amorphous silicon layer 5. However, the top solar cell 25 may have an n-i-p structure. The bottom solar cell 35 has a p-i-n structure, and is composed of a p-type crystalline silicon layer 6, an i-type crystalline silicon layer 7 and an n-type crystalline silicon layer 8. However, the bottom solar cell 35 may have an n-i-p structure, when the top solar cell has the n-i-p structure.

Here, the intermediate transparent layer 20 reflects a spectrum region of the entering sun light used for the power generation in the amorphous silicon solar cell as the top solar cell 25 such that the reflected sunlight spectrum region reenters the amorphous silicon solar cell of the top solar cell 25. As a result, the power generation efficiency of the amorphous silicon solar cell of the top solar cell 25 can be improved compared with the first embodiment. For this purpose, the intermediate transparent layer 20 is formed of a material containing ZnO, ITO (Indium Thin Oxide) or SnO₂ as a main component. The thickness of the intermediate transparent layer 20 is about 50 nm, and an absorptivity of the light in the wavelength of 600 to 1200 nm by the intermediate layer 20 is equal to or less than 1%.

Also, although the top solar cell 25 and the bottom solar cell 35 have the silicon layers, the components of the top solar cell and the bottom solar cell is not limited to pure silicon. The layer may be a layer containing silicon as a major component, such as a silicon carbide layer containing less than 50 percent of carbon, and a silicon germanium layer containing less than 20 percent of germanium. Even if several percent or below of other elements are contained, the same characteristic is shown when the silicon is substantially the major component.

Also, although it has been described that all the p-, i-, and n-type silicon layers in the amorphous solar cell as the top solar cell are amorphous, a crystallinity of the p-type layer and the n-type layer is not a problem, since the characteristic of the amorphous silicon solar cell is substantially determined depending on the major component of the i-type silicon layer. Similarly, although it has been described that all the p-, i-, and n-type silicon layers in the crystalline solar cell as the bottom solar cell are crystalline, the crystallinity of the p-type layer and the n-type layer is not a problem, since the characteristics of the crystalline silicon solar cell are substantially determined depending on the main component of the i-type silicon layer.

Similarly to the first embodiment, the thicker the film thickness of the top solar cell 25 and the bottom solar cell 35 is, the greater the generation electric currents in each of the cells become. Therefore, in order to freely set the balance of the generation electric currents in the top solar cell 25 and the bottom solar cell 35, the film thickness of the top solar cell 25 is made constant to fix the generation electric currents in the top solar cell 25. Then, by adjusting the film thickness of the bottom solar cell 35, the balance of the generation electric currents in the top solar cell 25 and the bottom solar cell 35 is freely set. That is, the film thickness of the top solar cell 25 is fixed and that of the bottom solar cell 35 is adjusted. Thus, the top solar cell determining rule of the total generation electric current is consequently realized.

In the second embodiment, the film thickness of the amorphous silicon solar cell 25 as the top solar cell is preferably in a range of 200 to 400 nm. When the film thickness of the amorphous silicon solar cell 25 as the top solar cell, is 250nm, and that of the intermediate transparent layer 20 is 50nm, a plurality of generation electric currents balance values of the top solar cell and the bottom solar cell are set to various values by setting the film thickness of the crystalline silicon solar cell 35 as the bottom solar cell. Then, in each generation electric currents balance, a stabilization efficiency in the sunlight radiation of AM (Air Mass) 1.5. The stabilization efficiency means an efficiency after light radiation degradation of 1 SUN and 100 mW/cm², at 50 °C, for 1000 hours.

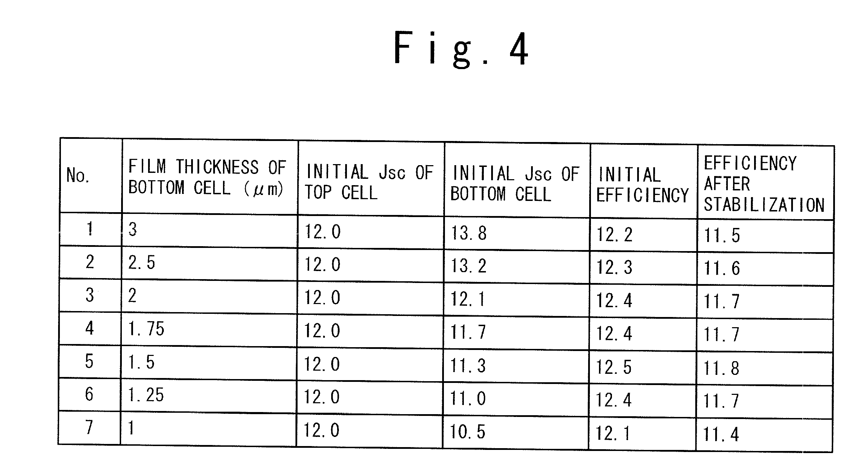

Fig. 4 shows the stabilization efficiency corresponding to each generation electric currents balance when balance of the generation electric currents in the top solar cell 25 and the bottom solar cell 35 is changed, in the thin-film solar cell of the tandem type in the second embodiment. As shown in Fig. 4, the generation electric current in the bottom solar cell 35 is set to be equal or smaller by 1 mA/cm² than that of the top solar cell. This is the optimum setting condition to maximize the stabilization efficiency, even when the intermediate transparent layer 20 is laminated. That is, the bottom solar cell determining rule of the total generation electric current is achieved. In this case, the film thickness of the bottom solar cell is in a range of 2 µm to 1.25 µm. The film thickness of 1.5µm is the optimum value as the film thickness of the bottom solar cell 35 in view of productivity.

A rated output of the solar cell is to be based on the sunlight spectrum of AM (Air Mass) 1.5. In order to obtain a high rated output, the generation electric current balance of the bottom solar cell layer 35 and the top solar cell layer 25 is designed such that the generation electric current in the bottom solar cell layer is equal to or smaller than that in the top solar cell layer by about 1 mA/cm², in the sunlight spectrum of AM 1.5. Through such a design, the high output can be obtained as a characteristic of a tandem solar cell, in present solar cell characteristic evaluation defined for crystalline solar cell evaluation.

In order to obtain a high effective output of the solar cell actually placed out of doors, it is necessary to take into consideration a sunlight spectrum condition in a place where the solar cell is to be located, and to design the solar cell such that the bottom solar cell determining rule of the total generation electric current is realized. Since the sunlight spectrum changes in the seasons, the sunlight spectrum at the time of the noon in March or September, which are the vernal equinox and the autumnal equinox, is applied as an average value. The film thickness of the bottom solar cell is optimized such that the bottom solar cell determining rule of the total generation electric current is met under that condition.

In the second embodiment, the thin-film solar cell of the tandem type set in the bottom solar cell determining rule of the total generation electric current is realized. Consequently, it is possible to realize a higher power generation efficiency throughout the year than the first embodiment. Also, by establishing the bottom solar cell determining rule of the total generation electric current, it is also possible to stably keep a stabilization efficiency even for a drop in the power generation efficiency after the degradation of the amorphous silicon solar cell 25 as the top solar cell. Further, for the reason of the bottom solar cell determining rule of the total generation electric current, a high deposition accuracy is not required for the film thickness of the amorphous silicon solar cell 25 as the top solar cell. That is, in the first embodiment, the stabilization efficiency is stable and the productivity is high, even if the film thickness ratio of the top solar cell and the bottom solar cell is not a perfect value to a certain extent.

Further, in the second embodiment, the intermediate transparent layer 20 is formed between the amorphous silicon solar cell as the top solar cell 25 and the crystalline silicon solar cell as the bottom solar cell 35. As a result, it is possible to improve the power generation efficiency in the amorphous silicon solar cell of the top solar cell 25 to improve the stabilization efficiency of the solar cell as a whole. In addition, since the film thickness itself of the amorphous silicon solar cell as the top solar cell 25 can be made thinner, it is possible to improve the productivity of the amorphous silicon solar cell of the top solar cell 25 and a light degradation characteristics.

According to the present invention, it is possible to provide a thin-film solar cell of a tandem type that is high in efficiency throughout the year and can be manufactured in a high productivity, and a design method of the same.

## Claims

1. A thin-film solar cell of a tandem type, comprising:
a first conductive layer formed on a transparent substrate to which a sun light is input;
a top solar cell layer formed on said first conductive layer; and
a bottom solar cell layer laminated on said top solar cell layer to be connected with said top solar cell in series,
wherein a total generation electric current of said thin-film solar cell layer is determined based on a generation electric current of said bottom solar cell layer.

2. The thin-film solar cell according to claim 1, further comprising:
an intermediate transparent layer provided between said top solar cell layer and said bottom solar cell layer.

3. The thin-film solar cell according to claim 2, wherein said intermediate transparent layer layer is formed of a material selected from the group consisting of ZnO, ITO (Indium Thin Oxide) and SnO₂, as a main component.

4. The thin-film solar cell according to claim 2 or 3, wherein a thickness of said intermediate transparent layer layer is about 50 nm.

5. The thin-film solar cell according to any of claims 2 to 4, wherein an absorptivity of light in the wavelength of 600 to 1200 nm by said intermediate transparent layer layer is equal to or less than 1%.

6. The thin-film solar cell according to any of claims 2 to 5, wherein said intermediate transparent layer is provided to reflect a wavelength region of a sun light, which should be used for power generation in said top solar cell layer, to said top solar cell layer.

7. The thin-film solar cell according to any of claims 1 to 6, wherein a film thickness of said top solar cell is in a range of 200 to 400 nm, and
a film thickness of said bottom solar cell layer is in a range of 1 to 2.5 µm.

8. The thin-film solar cell according to claim 7, wherein a film thickness of said bottom solar cell layer is in a range of 1.5 to 2.0 µm.

9. The thin-film solar cell according to any of claims 1 to 8, wherein the generation electric current in said top solar cell layer is equal to or smaller than a generation electric current in said bottom solar cell layer under a sun light spectrum condition of AM (Air Mass) of 1.5.

10. The thin-film solar cell according to any of claims 1 to 8, wherein the generation electric current in said top solar cell layer is equal to or smaller than a generation electric current in said bottom solar cell layer under a condition of a sunlight spectrum at noon in March or September at a location where said thin-film solar cell layer is installed.

11. The thin-film solar cell according to claim 9 or 10, wherein the generation electric current in said bottom solar cell layer is equal to or smaller than a generation electric current in said bottom solar cell layer by a value smaller than 1 mA/cm² under a sun light spectrum condition of AM (Air Mass) of 1.5.

12. The thin-film solar cell according to any of claims 1 to 11, wherein said top solar cell layer comprises a p-type layer, an i-type layer and an n-type layer, and
said i-type layer is an amorphous layer.

13. The thin-film solar cell according to claim 12, wherein said bottom solar cell layer comprises a p-type layer, an i-type layer and an n-type layer, and
said i-type layer is an crystalline layer.

14. The thin-film solar cell according to claim 13, wherein said p-, i- and n-type layers of said top solar cell layer are formed on said first conductive layer in this order, and said p-, i- and n-type layers of said bottom solar cell layer are formed from a side of said first conductive layer in this order.

15. The thin-film solar cell according to claim 13, wherein said n-, i- and p-type layers of said top solar cell layer are formed on said first conductive layer in this order, and said n-, i- and p-type layers of said bottom solar cell layer are formed from a side of said first conductive layer in this order.

16. The thin-film solar cell according to any of claims 1 to 15, wherein a main component of said top solar cell layer and said bottom solar cell layer is silicon.
